# EUROPÄISCHE PATENTSCHRIFT

(11) **EP 0 447 593 B1**
(45) Veröffentlichungstag und Bekanntmachung des Hinweises auf die Patenterteilung: **29.06.1994**
(21) Anmeldenummer: 90105500.4
(22) Anmeldetag: 23.03.1990
(51) Int. Cl.: H03G 3/20

(54) **Schaltung zur automatischen Verstärkungsregelung in MOS-Technik**
AGC circuit using MOS-technology
Circuit CAG utilisant la technologie MOS

(43) Veröffentlichungstag der Anmeldung: 25.09.1991
(73) Patentinhaber: Deutsche ITT Industries GmbH, 79108 Freiburg (DE)
(72) Erfinder: Luther, Rainer, Dipl.-Ing., D-4100 Duisburg 17 (DE)

(56) Entgegenhaltungen:
- GB-A- 2 166 014
- US-A- 3 464 022
- US-A- 3 879 672
- US-A- 4 066 977
- US-A- 4 910 797

## Beschreibung

Die Erfindung betrifft eine Schaltung zur automatischen Verstärkungsregelung in MOS-Technik, die über einen digital einstellbaren Verstärker ein analoges Signal, insbesondere ein Audiosignal, auf einen konstanten Amplitudenwert regelt. In der Regel liegt das analoge Signal gleichspannungsfrei als Wechselsignal vor und schwankt als positives/negatives Signal um den Nullwert oder einen anderen schaltungsbedingten Bezugswert. Durch die Schaltung zur automatischen Verstärkungsregelung kann beispielsweise die Aussteuerkennlinie eines Analog/Digital-Umsetzers weitgehend ausgenutzt werden, so daß die Auflösung des digitalisierten Signals möglichst hoch wird.

Bei derartigen Schaltungen zur automatischen Verstärkungsregelung wird in der Regel ein Toleranzschlauch angegeben, in dem die jeweilige Signalamplitude liegen soll. Die Breite dieses Toleranzschlauches oder Hysteresebereiches hängt natürlich von der Art des analogen Signals ab. Je sinusförmiger das Signal ist, desto enger kann der Hysteresebereich sein. Bei Audiosignalen, die beispielsweise auch von einem Stereo-Hilfsträger überlagert sein können, wird der Hysteresebereich so gewählt, daß die automatische Verstärkungsregelung nicht schon auf übliche, kurzzeitige Signalschwankungen anspricht und so zu Verzerrungen führt.

In EP-A 325 252 ist eine Schaltung zur automatischen Verstärkungsregelung mit einem digital einstellbaren Verstärker beschrieben. Dessen Ausgang ist auf eine Spitzenwert-Abtast-Halteschaltung geführt, deren analoges Ausgangssignal mittels eines Fensterkomparators bewertet wird. Der Hysteresebereich dieses Fensterkomparators ist durch zwei Referenzspannungen bestimmt, die jeweils einen Referenzeingang zweier im Fensterkomparator enthaltener Komparatoren speisen. Die Ausgangssignale der beiden Komparatoren sind auf eine Steuerstufe geführt, die mittels eines Auf-und-Abwärtszählers ein digitales Steuersignal für den digital einstellbaren Verstärker erzeugt. Mittels zweier zugeführter Taktsignale kann die Abtastrate unterschiedlich vorgegeben werden.

Ein Nachteil dieser bekannten Schaltungsanordnung ist, daß sie sich nicht zur Realisierung in monolithisch integrierter MOS-Technik, insbesondere ohne äußere Bauelemente, eignet. Denn das Festhalten der abgetasteten analogen Spannungswerte erfordert bei den relativ niederen Abtastraten hohe Speicherkapazitäten, die im Hinblick auf die erforderliche Chipfläche kaum zu realisieren sind.

In US-A 4 910 797 ist als nächstliegender Stand der Technik eine gemischte analoge und digitale Schaltung zur automatischen Verstärkungsregelung beschrieben, die digital arbeitende Schaltungseinheiten enthält, um die mittels digitaler Halteeinrichtungen bestimmte Signalgröße an einen vorgegebenen Wert anzupassen. Dabei wird die Verstärkung in Stufen über Inkrementschritte erhöht oder erniedrigt, wobei die Taktrate bei der Amplitudenaufregelung höher als bei der Amplitudenabregelung ist, vgl. auch den Wortlaut des Oberbegriffs von Anspruch 1.

Der in den Ansprüchen gekennzeichneten Erfindung liegt die Aufgabe zugrunde, eine Schaltung zur automatischen Verstärkungsregelung anzugeben, die sich als kompakte Schaltungseinheit in MOS-Technik, insbesondere in CMOS-Technik, monolithisch integrieren läßt und deren Halteeinrichtungen an die unterschiedliche Taktrate angepaßt sind.

Der wesentliche Gedanke der Erfindung besteht darin, daß die Spitzenwert-Abtast-Halteschaltung für das analoge Signal entfallen kann, weil die Fensterkomparatoren direkt mit dem analogen Signal gespeist werden. In diesem Fall ist anstatt der aufwendigen Spitzenwert-Abtast-Halteschaltung nur noch eine einfache digitale Halteschaltung (= latch) für die binären Ausgangssignale der Fensterkomparatoren erforderlich. Dadurch, daß nur noch Logikzustände gespeichert werden müßen, erübrigen sich auch die ansonsten erforderlichen Treiberschaltungen zur Umladung der Speicherkondensatoren in der Spitzenwert-Abtast-Halteschaltung.

Die Erfindung wird nun anhand der Figuren näher erläutert:
Fig.1 zeigt schematisch als Blockschaltbild ein Ausführungsbeispiel der Erfindung,
Fig.2 zeigt ein schematisches Zeitdiagramm des analogen Signals mit den zugehörigen Regelbereichen und
Fig.3 zeigt ein vorteilhaftes Ausführungsbeispiel des ersten Schwellwertdetektors in CMOS-Technik.

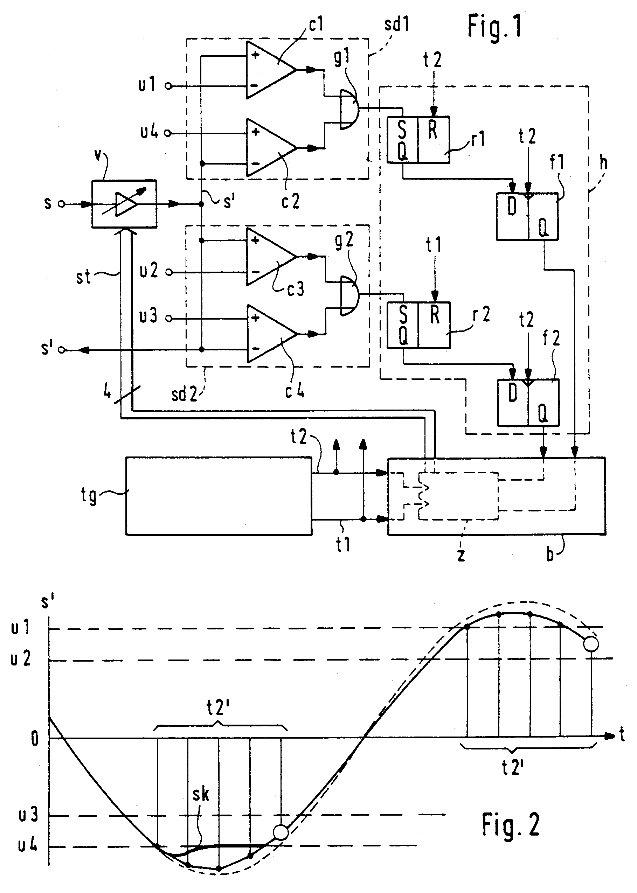

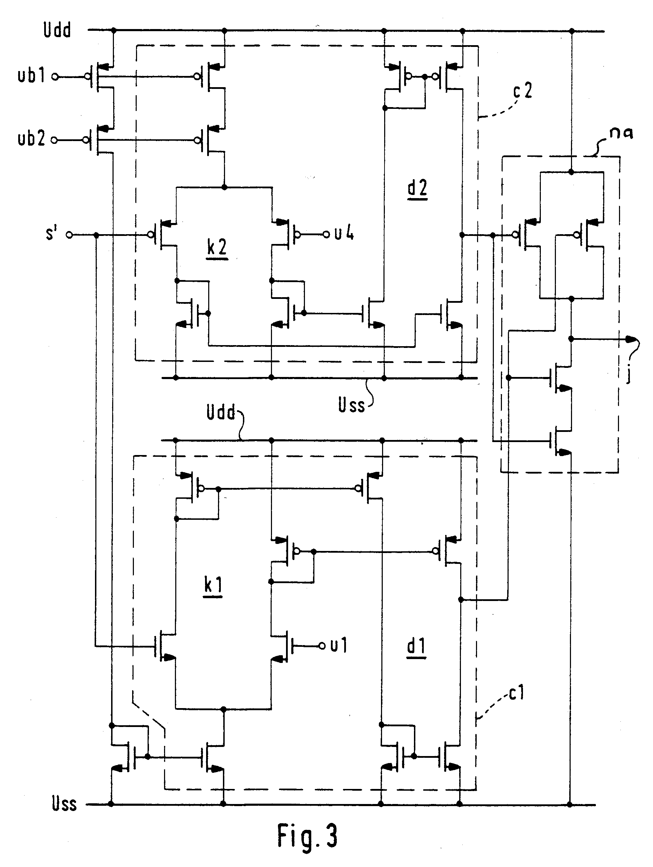

Die in Fig.1 dargestellte schematische Ausführungsbeispiel der Schaltung zur automatischen Verstärkungsregelung wertet im Gegensatz zur Schaltung aus EP-A 325 252 zwei symmetrisch liegende Hysteresebereiche u1, u2; u3, u4 mittels der Schwellwertdetektoren sd1, sd2 aus. Dieses Meßverfahren ist insbesondere dann vorteilhaft, wenn das zu regelnde analoge Signal s mehr oder weniger stark von einem idealen sinusförmigen Verlauf abweicht, was in der Regel bei Audiosignalen der Fall ist. Hier bringt die beidseitige Amplitudenerfassung Vorteile für das gleichmäßige Regelverhalten. Aus der Fig.2 ist ersichtlich, daß dem ersten Schwellwertdetektor sd1 von den beiden Hysteresebereichen die erste und vierte Schwellwertreferenz u1, u4 (= äußere Grenzwerte) zugeordnet sind und daß dem zweiten Schwellwertdetektor sd2 von den beiden Hysteresebereichen die zweite und dritte Schwellwertreferenz u2, u3 (= innere Grenzwerte) zugeordnet sind. Die beiden Schwellwertdetektoren sind mit ihrem Signaleingang an den Ausgang eines digital einstellbaren Verstärkers v angeschlossen, dessen Steuereingang von einem Steuersignal st gespeist ist, das beispielsweise vier Binärstellen umfaßt. Dies erlaubt die Einstellung von 16 unterschiedlichen Verstärkungsstufen. Jeder der beiden Schwellwertdetektoren sd1, sd2 enthält im Eingang zwei Komparatoren c1, c2; c3, c4, wobei in jedem Schwellwertdetektor die beiden Komparatorausgangssignale mittels eines Gatters g1, g2 logisch miteinander verknüpft sind. Im dargestellten Ausführungsbeispiel von Fig.1 sind die beiden Gatter g1, g2 als ODER-Verknüpfungen ausgeführt. Das bevorzugte Ausführungsbeispiel nach Fig.3 zeigt eine Ausführung als NAND-Gatter, wobei die vier Komparatoren c1 bis c4 über ihre invertieren Komparatorausgangssignale miteinander verknüpft werden. Dies ist nach den Gesetzen der logischen Umformung indessen logisch äquivalent.

Der Minuendeingang des ersten und dritten Komperators c1, c3 und der Subtrahendeingang des zweiten und vierten Komperators c2, c4 liegen gemeinsam am Ausgang des digital einstellbaren Verstärkers v. Der Subtrahendeingang des ersten bzw. des dritten Komperators c1, c3 ist mit der ersten bzw. mit der zweiten Schwellwertreferenz u1, u2 gespeist. Der Minuendeingang des vierten bzw. des zweiten Komperators c4, c2 ist mit der dritten bzw. mit der vierten Schwellwertreferenz u3, u4 gespeist. Damit liegen die beiden Hysteresebereiche fest. Wenn das analoge Signal s bzw. s' mit einem Gleichpegel behaftet ist, dann liegen die beiden Hysteresebereiche symmetrisch um diesen Gleichpegelwert.

Den beiden Schwellwertdetektoren sd1, sd2 ist die Halteeinrichtung h nachgeschaltet, deren beide binären Ausgangssignale auf den Dateneingang einer Steuerstufe b geschaltet sind. Je nach dem Logikzustand dieser zugeführten Signale wird ein interner Auf-und-Abwärtszähler z um einen Zählschritt in Auf- oder Abwärtszählrichtung verändert oder bleibt unverändert. Der Zählerstand bleibt unverändert, wenn das verstärkte analoge Signal s' innerhalb des Hysteresebereiches u1, u2; u3, u4 liegt. Der Zähltakt wird von einem Taktgeber tg gesteuert, der einen ersten und einen zweiten Takt t1, t2 mit unterschiedlicher Taktrate abgibt, wobei der zweite Takt eine höhere Taktrate als der erste Takt aufweist. Durch die unterschiedliche Zählgeschwindigkeit wird erreicht, daß die Amplitudenabregelung eines zu großen verstärkten Signals s' sehr schnell erfolgt, um das Signal rasch aus dem Übersteuerungsbereich mit hohem Klirrfaktor herauszubringen.

Die Amplitudenaufregelung erfolgt demgegenüber langsam, damit selbst bei niederfrequenten Signalen mehrere Signalspitzen im Meßintervall erfaßt und ausgewertet werden können. Das Meßintervall ist durch die Periodendauer des niederfrequenten ersten Taktes t1 vorgegeben. Nur wenn alle Amplitudenspitzen innerhalb des durch die zweite und dritte Schwellwertreferenz u2, u3 vorgegebenen inneren Grenzbereichs liegen, wird die Verstärkung um eine Stufe erhöht.

Der unterschiedlichen Zählgeschwindigkeit entsprechen bei der Halteeinrichtung h unterschiedliche Abtastraten für die Speicherung der Ausgangssignale des ersten und zweiten Schwellwertdetektors sd1, sd2. Zur Abtastung des ersten Schwellwertdetektors sd1 ist dessen Ausgang mit dem Setzeingang S eines ersten RS-Flipflops r1 verbunden, dessen Rücksetzeingang R mit dem zweiten Takt t2 gespeist ist. Entsprechend ist der Ausgang des zweiten Schwellwertdetektors sd2 mit dem Setzeingang S eines zweiten RS-Flipflops r2 verbunden, dessen Rücksetzeingang R mit dem ersten Taktsignal t1 gespeist ist. Der Q-Ausgang Q des ersten bzw. des zweiten RS-Flipflops r1, r2 ist mit dem D-Eingang eines ersten bzw. eines zweiten D-Flipflops f1, f2 verbunden, dessen Q-Ausgang Q auf jeweils eine Stelle des Dateneingangs der Steuerstufe b geschaltet ist. Der Takteingang des ersten D-Flipflops f1 ist mit dem zweiten Takt t2 und der Takteingang des zweiten D-Flipflops f2 ist mit dem ersten oder mit dem zweiten Takt t1, t2 gespeist.

Die Speichereinrichtungen in der Halteeinrichtung h können auch auf andere Weise realisiert sein, beispielsweise durch adressierbare Lese/Schreib-Speicher (= RAM), die konkurrierend von den Ausgangssignalen der beiden Schwellwertdetektoren sd1, sd2 und den beiden Takten t1, t2 überschrieben oder gelöscht werden. Der jeweils vorhandene Speicherinhalt dient dann als Eingangssignal für die Steuerstufe b.

Für die Bemessung der Zählrate der beiden Takte t1, t2 dienen folgende Überlegungen. Ist die Zählrate des zweiten Taktes t2 zu hoch, dann besteht die Gefahr, daß zu viele Zähltakte in die Signalspitzen fallen, so daß diese durch die schnelle Abwärtsregelung deformiert werden und daher ein Klirrfaktor auftritt. Ist die Zählrate des zweiten Taktes t2 indessen zu langsam, dann dauert die Abwärtsregelung zu lang und das Signal bleibt zu lange im Übersteuerungsbereich. Durch Versuche erweist sich, daß für den zweiten Takt t2 ein Bereich von 500 Hz bis 2 kHz einen guten Kompromiß darstellt.

Der niederfrequentere erste Takt t1 ist gegenüber dem zweiten Takt t2 um mindestens 2 bis 3 Zehnerpotenzen langsamer. Durch Versuche ergibt sich, daß für den ersten Takt t1 der Frequenzbereich von 0,5 Hz bis 2 Hz einen guten Kompromiß darstellt. Für die Schaltungsrealisation erweist sich ein Frequenzteilungsfaktor von 2¹⁰, also ca. 1000, als vorteilhaft. Dann kann der langsame erste Takt t1 durch einfache binäre Frequenzteilung aus dem schnellen zweiten Takt t2 erzeugt werden.

In Fig.2 ist der zeitliche Verlauf eines verstärkten Signals s' dargestellt, dessen Amplitude zu groß ist. Die erforderliche Abwärtsregelung erfolgt in den mit t2' angegebenen Bereichen im Takt des zweiten Taktes t2. Dieser ist schematisch im Zeitdiagramm jeweils als senkrechte Linie mit kleinem Kreis dargestellt. Der kleine Kreis soll andeuten, daß der digital einstellbare Verstärker v seine Verstärkung zurücknimmt und der große Kreis soll andeuten, daß die Verstärkung gleich bleibt. Die gestrichelte Linie gibt den Signalverlauf ohne Verstärkungsabregelung an. Aus dem Zeitdiagramm ist ferner leicht entnehmbar, daß bei einer zu hohen Taktrate des zweiten Taktes t2 das verstärkte Signal s' entsprechend dem dargestellten Signalverlauf sk hart begrenzt würde.

Die im Blockschaltbild der Fig.1 dargestellte Schaltungsanordnung enthält Teilschaltungen, die sich sowohl in MOS-Technik als auch in Bipolartechnik, sowie in diskreter und sogar gemischter Ausführung realisieren lassen. Die Vorteile der Erfindung kommen jedoch im wesentlichen erst bei der monolithischen Integration eines größeren Schaltungssystems zum Tragen, weil die gesamte Anordnung eine kompakte Untereinheit ohne äußere Anschlüsse auf der Chipfläche der Gesamtschaltung darstellt. Ob diese in n-, p-Kanal- oder CMOS-Technik realisiert ist hängt von anderen Gesichtspunkten ab, beispielsweise der vorgegebenen Verarbeitungsgeschwindigkeit der Gesamtschaltung.

In Fig.3 ist ein vorteilhaftes Ausführungsbeispiel der Schaltung des ersten Schwellwertdetektors sd1 in CMOS-Technik dargestellt. Der erste und der zweite Komparator c1, c2 bestehen dabei jeweils aus einem ersten bzw. einem zweiten Transkonduktanz-Verstärker k1, k2, dessen einem Eingang das verstärkte analoge Signal s' und dessen anderem Eingang die erste bzw. die vierte Schwellwertreferenz u1, u4 zugeführt ist. Der Ausgang des ersten bzw. des zweiten Transkonduktanzverstärkers k1, k2 ist auf eine erste bzw. zweite Stromdifferenzstufe d1, d2 geführt, deren Ausgangssignal das erste bzw. das zweite Komparatorausgangssignal ist.

Der erste Transkonduktanz-Verstärker k1 enthält als Eingangsstufe ein n-Kanal-Transistorpaar, dessen gemeinsamer Source-Anschluß über eine n-Kanal-Stromquelle mit der negativen Versorgungsspannung Uss verbunden ist. Der zweite Transkonduktanz-Verstärker k2 enthält als Eingangsstufe ein p-Kanal-Transistorpaar, dessen gemeinsamer Source-Anschluß über eine kaskodierte p-Kanal-Stromquelle aus der positiven Versorgungsspannung Udd gespeist ist. Die Vorspannungseinstellung dieser p-Kanal-Stromquelle erfolgt durch eine zugeführt erste und zweite Vorspannung ub1, ub2. Eine parallelgeschaltete zweite p-Kanal-Stromquelle ist über den Eingang eines n-Kanal-Stromspiegels mit der negativen Versorgungsspannung Uss verbunden, wobei der Ausgang dieses n-Kanal-Stromspiegels als n-Kanal-Stromquelle für den ersten Transkonduktanz-Verstärker k1 dient. Die Ausgangsströme der beiden Transkonduktanz-Verstärker k1, k2 sind über p- bzw. n-Kanal-Stromspiegelschaltungen in die erste bzw. zweite Stromdifferenzstufe d1, d2 eingekoppelt. Die Ausgangssignale der ersten und der zweiten Stromdifferenzstufe d1, d2 stellen das erste bzw. das zweite Komparatorausgangssignal dar, das jeweils einen Eingang eines NAND-Gatters na in CMOS-Technik speist. Die Ausgangssignal j dieses NAND-Gatters ist das Ausgangssignal des ersten Schwellwertdetektors sd1.

In gleicher Weise wie der erste Schwellwertdetektor sd1 ist der zweite Schwellwertdetektor sd2 in CMOS-Technik realisiert, eine gesonderte Darstellung erübrigt sich daher. Statt der ersten bzw. vierten Schwellwertreferenz u1, u4 ist dann die zweite bzw. dritte Schwellwertreferenz u2, u3 an den Referenzeingang des dem ersten bzw. zweiten Komparators c1, c2 entsprechenden dritten bzw. vierten Komparators c3, c4 anzuschließen.

## Patentansprüche

1. Schaltung zur automatischen Verstärkungsregelung mit
- einem digital einstellbaren Verstärker (v),
- mindestens einem ersten und zweiten Schwellwertdetektor (sd1, sd2) mit einstellbarer Hysterese,
- einer Halteeinrichtung (h),
- einer Steuerstufe (b) mit einem Auf-und-Abwärtszähler (z), der ein Steuersignal (st) zur Steuerung des digital einstellbaren Verstärkers (v) liefert und
- eine mit der Halteeinrichtung (h) gekoppelte Taktgebereinrichtung (tg), die als Abtasttakte einen ersten und einen zweiten Takt (t1, t2) erzeugt, dessen Taktrate höher als diejenige des ersten Taktes ist,
-- der erste und zweite Schwellwertdetektor (sd1, sd2) unmittelbar am Ausgang des digital einstellbaren Verstärkers angeschlossen sind,
-- die Ausgangssignale des ersten und des zweiten Schwellwertdetektors (sd1, sd2) als Binärsignale in der Halteeinrichtung (h) festgehalten sind,
-- die Ausgangssignale der Halteeinrichtung (h) mit der Steuerstufe (b) gekoppelt sind und je nach dem Logikzustand dieser Signale der Auf-und-Abwärtszähler (z) um einen Inkrementschritt erhöht oder erniedrigt wird oder unverändert bleibt,
-- die Amplitudenaufregelung vom ersten Takt (t1) gesteuert ist und
-- die Amplitudenabregelung vom zweiten Takt (t2) gesteuert ist und eine größere Amplitudenänderungsrate aufweist als die Amplitudenaufregelung,
dadurch gekennzeichnet, daß
- die Schaltung in MOS-Technik hergestellt ist und
- der zweite bzw. der erste Takt (t2, t1) dem ersten bzw. dem zweiten Schwellwertdetektor (sd1, sd2) als Abtast-undHaltetakt zugeordnet ist.

2. Schaltung nach Anspruch 1, gekennzeichnet durch folgende Merkmale:
- der erste Schwellwertdetektor (sd1) enthält in seinem Eingang einen ersten und einen zweiten Komparator (c1, c2),
- der zweite Schwellwertdetektor (sd2) enthält in seinem Eingang einen dritten und einen vierten Komparator (c3, c4),
- der Minuendeingang des ersten und des dritten Komparators (c1, c3) und der Subtrahendeingang des zweiten und des vierten Komparators (c2, c4) liegen gemeinsam am Ausgang des digital einstellbaren Verstärkers (v),
- der Subtrahendeingang des ersten und des dritten Komparators (c1, c3) ist an eine erste bzw. eine zweite Schwellwertreferenz (u1, u2) angeschlossen,
- der Minuendeingang des vierten bzw. des zweiten Komparators (c4, c2) ist an eine dritte bzw. eine vierte Schwellwertreferenz (u3, u4) angeschlossen,
- die Ausgänge des ersten und des zweiten Komparators (c1, c2) sind über ein erstes Gatter (g1) miteinander verknüpft und
- die Ausgänge des dritten und vierten Komparators (c3, c4) sind über ein zweites Gatter (g2) miteinander verknüpft.

3. Schaltung nach Anspruch 2, dadurch gekennzeichnet, daß die Halteschaltung (h) folgende Teilschaltungen enthält:
- ein erstes RS-Flipflop (r1), dessen Setzeingang (S) mit dem ersten Gatter (g1) gekoppelt ist und dessen Rücksetzeingang (R) am zweiten Takt (t2) liegt,
- ein zweites RS-Flipflop (r2), dessen Setzeingang (S) mit dem zweiten Gatter (g2) gekoppelt ist und dessen Rücksetzeingang (R) am ersten Takt (t1) liegt,
- ein erstes bzw. ein zweites D-Flipflop (f1, f2), dessen D-Eingang (D) am Q-Ausgang (Q) des ersten bzw. des zweiten RS-Flipflops (r1, r2) liegt und dessen Takteingang mit dem zweiten Takt (t2) bzw. mit dem ersten oder zweiten Takt (t1, t2) gespeist ist und
- der Q-Ausgang (Q) des ersten und des zweiten D-Flipflops (f1, f2) ist mit dem Dateneingang der Steuerstufe (b) verbunden.

4. Schaltung nach Anspruch 2, dadurch gekennzeichnet, daß das erste und das zweite Gatter (g1, g2) jeweils ein ODER-Gatter ist.

5. Schaltung nach Anspruch 2, dadurch gekennzeichnet, daß die Ausgangssignale des ersten, zweiten, dritten und vierten Komparators (c1, ...c4) jeweils invertiert sind und daß das erste und das zweite Gatter (g1, g2) jeweils ein NAND-Gatter (na) ist.

6. Schaltung nach Anspruch 5, gekennzeichnet durch folgende Merkmale:
- der erste Schwellwertdetektor (sd1) enthält in seinem ersten Komparator (c1) als Eingangsstufe einen ersten Transkonduktanz-Verstärker (k1) mit einem n-Kanal-Transistorpaar, dessen gemeinsamer Source-Anschluß über eine n-Kanal-Stromquelle gespeist ist, und
-- die Drain-Ströme des n-Kanal-Transistorpaares sind mit einer ersten Stromdifferenzstufe (d1) gekoppelt, deren Ausgangssignal das erste Komparatorausgangssignal ist,
- der erste Schwellwertdetektor (sd1) enthält in seinem zweiten Komparator (c2) als Eingangsstufe einen zweiten Transkonduktanz-Verstärker (k2) mit einem p-Kanal-Transistorpaar, dessen gemeinsamer Source-Anschluß über eine p-Kanal-Stromquelle gespeist ist, und
-- die Drain-Ströme des p-Kanal-Transistorpaares sind mit einer zweiten Stromdifferenzstufe (d2) gekoppelt, deren Ausgangssignal das zweite Komparatorausgangssignal ist und
das erste und das zweite Komparatorausgangssignal speisen die beiden Eingänge eines NAND-Gatters (na).

7. Schaltung nach Anspruch 5, gekennzeichnet durch folgende Merkmale:
- der erste Schwellwertdetektor (sd1) enthält in seinem ersten Komparator (c1) als Eingangsstufe einen ersten Transkonduktanz-Verstärker (k1) mit einem n-Kanal-Transistorpaar, dessen gemeinsamer Source-Anschluß über eine n-Kanal-Stromquelle gespeist ist, und
-- die Drain-Ströme des n-Kanal-Transistorpaares sind mit einer ersten Stromdifferenzstufe (d1) gekoppelt, deren Ausgangssignal das erste Komparatorausgangssignal ist,
- der erste Schwellwertdetektor (sd1) enthält in seinem zweiten Komparator (c2) als Eingangsstufe einen zweiten Transkonduktanz-Verstärker (k2) mit einem p-Kanal-Transistorpaar, dessen gemeinsamer Source-Anschluß über eine p-Kanal-Stromquelle gespeist ist, und
-- die Drain-Ströme des p-Kanal-Transistorpaares sind mit einer zweiten Stromdifferenzstufe (d2) gekoppelt, deren Ausgangssignal das zweite Komparatorausgangssignal ist,
- das erste und das zweite Komparatorausgangssignal speisen die beiden Eingänge eines NAND-Gatters (na) und
- der zweite Schwellwertdetektor (sd2) ist identisch zum ersten Schwellwertdetektor (sd1), wobei an den Subtrahendeingang des zugehörigen ersten bzw. zugehörigen zweiten Komparators (c1, c2) die zweite bzw. dritte Schwellwertreferenz (u2, u3) anzuschließen ist.

## Claims

1. An automatic gain control circuit in MOS technology comprising
- a digitally adjustable amplifier (v),
- at least a first and a second threshold detector (sd1, sd2) with adjustable hysteresis,
- a latch (h),
- a control stage (b) including an up-down counter (z) which provides a control signal (st) for controlling the digitally adjustable amplifier (v), and
- a clock generator (tg) coupled to the latch (h) and generating a first clock signal (t1) and a second clock signal (t2) as sampling clocks, the second clock signal having a higher clock rate than the first clock signal,
-- with the first and second threshold detectors (sd1, sd2) connected directly to the output of the digitally adjustable amplifier,
-- the output signals of the first and second threshold detectors (sd1, sd2) being held as binary signals in the latch (h),
-- the output signals of the latch (h) being coupled to the control stage (b), and the up-down counter (z) being incremented or decremented by one count or remaining unchanged depending on the logic states of said signals,
-- the amplitude increase being controlled by the first clock signal (t1), and
-- the amplitude decrease being controlled by the second clock signal (t2) and having a higher rate of change than the amplitude increase,
characterized in
- that the circuit is fabricated in MOS technology, and
- that the second and first clock signals (t2, t1) are assigned as sample-and-hold clocks to the first and second threshold detectors (sd1, sd2), respectively.

2. A circuit as claimed in claim 1, characterized by the following features:
- The first threshold detector (sd1) contains a first and a second comparator (c1, c2) in its input stage;
- the second threshold detector (sd2) contains a third and a fourth comparator (c3, c4) in its input stage;
- the minuend inputs of the first and third comparators (c1, c3) and the subtrahend inputs of the second and fourth comparators (c2, c4) are connected to the output of the digitally adjustable amplifier (v);
- the subtrahend inputs of the first and third comparators (c1, c3) are connected to a first threshold reference (u1) and a second threshold reference (u2), respectively;
- the minuend inputs of the fourth and second comparators (c4, c2) are connected to a third threshold reference (u3) and a fourth threshold reference (u4), respectively;
- the outputs of the first and second comparators (c1, c2) are combined via a first gate (g1), and
- the outputs of the third and fourth comparators (c3, c4) are combined via a second gate (g2).

3. A circuit as claimed in claim 2, characterized in that the latch (h) contains the following subcircuits:
- a first RS flip-flop (r1) whose set input (S) is coupled to the first gate (g1) and whose reset input (R) is supplied with the second clock signal (t2);
- a second RS flip-flop (r2) whose set input (S) is coupled to the second gate (g2) and whose reset input (R) is supplied with the first clock signal (t1);
- a second RS flip-flop (r2) whose set input (S) is coupled to the second gate (g2) and whose reset input (R) is supplied with the first clock signal (t1);
- a first D flip-flop (f1) whose D input (D) is connected to the Q output (Q) of the first RS flip-flop (r1) and whose clock input is supplied with the second clock signal (t2), and a second D flip-flop (f2) whose D input (D) is connected to the Q output (Q) of the second RS flip-flop (r2) and whose clock input is supplied with the first or second clock signal (t1, t2), and
- the Q outputs (Q) of the first and second D flip-flops (f1, f2) are connected to the data input of the control stage (b).

4. A circuit as claimed in claim 2, characterized in that the first and second gates (g1, g2) are OR gates.

5. A circuit as claimed in claim 2, characterized in that the outputs of the first, second, third and fourth comparators (c1, ..., c4) are inverted, and that the first and second gates (g1, g2) are NAND gates (na).

6. A circuit as claimed in claim 5, is characterized by the following features:
- The first threshold detector (sd1) contains in its first comparator (c1) as an input stage a first transconductance amplifier (k1) comprising an n-channel transistor pair whose common source terminal is fed via an n-channel current source, and
-- the drain currents of the n-channel transistor pair are coupled to a first current-difference stage (d1) whose output is the first comparator output signal;
- the first threshold detector (sd1) contains in its second comparator (c2) as an input stage a second transconductance amplifier (k2) comprising a p-channel transistor pair whose common source terminal is fed via a p-channel current source, and
-- the drain currents of the p-channel transistor pair are coupled to a second current-difference stage (d2) whose output is the second comparator output signal, and
- the first and second comparator output signals are applied to the two inputs of a NAND gate (na).

7. A circuit as claimed in claim 5, characterized by the following features:
- The first threshold detector (sd1) contains in its first comparator (c1) as an input stage a first transconductance amplifier (k1) comprising an n-channel transistor pair whose common source terminal is fed via an n-channel current source, and
-- the drain currents of the n-channel transistor pair are coupled to a first current-difference stage (d1) whose output is the first comparator output signal;
- the first threshold detector (sd1) contains in its second comparator (c2) as an input stage a second transconductance amplifier (k2) comprising a p-channel transistor pair whose common source terminal is fed via a p-channel current source, and
-- the drain currents of the p-channel transistor pair are coupled to a second current-difference stage (d2) whose output is the second comparator output signal,
- the first and second comparator output signals feed the two inputs of a NAND gate (na), and
- the second threshold detector (sd2) is identical to the first threshold detector (sd1), with the subrahend inputs of the corresponding first and second comparators (c1, c2) having to be connected to the second and third threshold references (u2, u3), respectively.

## Revendications

1. Circuit de réglage automatique d'amplification comportant
- un amplificateur réglable numériquement (v),
- au moins des premier et second détecteurs à valeur de seuil (sd1, sd2) possédant une hystérésis réglable,
- un circuit de blocage (h),
- un étage de commande (b) comportant un compteur progressif/régressif (z), qui délivre un signal de commande (st) pour commander l'amplificateur (v) réglable numériquement, et
- un dispositif générateur de cadences (tg) couplé au dispositif de blocage (h) et qui produit, comme cadences d'échantillonnage, une première cadence (t1) et une seconde cadence (t2), dont la valeur est supérieure à celle de la première cadence,
-- les premier et second détecteurs à valeur de seuil (sd1, sd2) sont connectés directement à la sortie de l'amplificateur réglable numériquement,
-- les signaux de sortie des premier et second détecteurs à valeur de seuil (sd1, sd2) sont bloqués sous la forme de signaux binaires dans le dispositif de blocage (h),
-- les signaux de sortie du dispositif de blocage (h) sont transmis à l'étage de commande (b) et, en fonction de l'état logique de ces signaux, l'état du compteur progressif/régressif (z) est accru ou réduit d'un pas d'incrémentation ou de décrémentation ou reste inchangé,
-- la régulation croissante d'amplitude est commandée par la première cadence (t1), et
-- la régulation décroissante d'amplitude est commandée par la seconde cadence (t2) et possède une cadence de variation d'amplitude, qui est supérieure à celle de la régulation croissante d'amplitude,
caractérisé en ce que
- le circuit est réalisé selon la technique MOS, et
- la seconde ou la première cadence (t2, t1) est associée en tant que cadence d'échantillonnage et de blocage au premier ou au second détecteur à valeur de seuil (sd1, sd2).

2. Circuit selon la revendication 1, caractérisé par les caractéristiques suivantes :
- le premier détecteur à valeur de seuil (sd1) contient, à son entrée, des premier et second comparateurs (c1, c2),
- le second détecteur à valeur de seuil (sd2) contient, à son entrée, des troisième et quatrième comparateurs (c3, c4),
- l'entrée dudiminuende des premier et second comparateurs (c1, c3) et l'entrée du nombre à soustraire des second et quatrième comparateurs (c2, c4) sont connectées en commun a la sortie de l'amplificateur (v) réglable numériquement,
- l'entrée du nombre à soustraire des premier et troisième comparateurs (c1, c3) est raccordée à des première et seconde références de valeur de seuil (u1, u2),
- l'entrée du diminuende des quatrième et second comparateurs (c4, c2) est raccordée à des troisième et quatrième références de valeur de seuil (u3, u4),
- les sorties des premier et second comparateurs (c1, c2) sont combinées entre elles par l'intermédiaire d'une première porte (g1), et
- les sorties des troisième et quatrième comparateurs (c3, c4) sont combinées entre elles par l'intermédiaire de la seconde porte (g2).

3. Circuit selon la revendication 2, caractérisé en ce que le circuit de blocage (h) contient les circuits partiels suivants :
- une première bascule bistable de type RS (r1), dont l'entrée de positionnement (S) est couplée à la première porte (g1) et dont l'entrée de remise à l'état initial (R) reçoit la seconde cadence (t2),
- une seconde bascule bistable de type RS (r2), dont l'entrée de positionnement (S) est couplée à la seconde porte (g2) et dont l'entrée de remise à l'état initial (R) reçoit la première cadence (t1),
- des première et seconde bascules bistables de type D (f1, f2), dont l'entrée D (D) est raccordée à la sortie Q (Q) des première et seconde bascules bistables de type RS (r1, r2) et dont l'entrée de cadence est alimentée avec la seconde cadence (t2) ou avec la première et la seconde cadence (t1, t2), et
- la sortie Q (Q) des première et second bascules bistables de type D (f1, f2) est reliée à l'entrée de données de l'étage de commande (b).

4. Circuit selon la revendication 2, caractérisé en ce que les première et seconde portes (g1, g2) sont formées chacune par une porte OU.

5. Circuit selon la revendication 2, caractérisé en ce que les signaux de sortie des premier, second, troisième et quatrième comparateurs (c1, ...c4) sont respectivement inversés et que les première et seconde portes (g1, g2) sont constituées chacune par une porte NON-ET (na).

6. Circuit selon la revendication 5, caractérisé par les caractéristiques suivantes :
- le premier détecteur à valeur de seuil (sd1) contient, dans son premier comparateur (c1), en tant qu'étage d'entrée, un premier amplificateur à transconductance (k1) possédant un couple de transistors à canal n, dont la borne de source commune est alimentée par l'intermédiaire d'une source de courant à canal n, et
-- les courants de drain des transistors du couple de transistors à canal n sont appliqués à un premier étage différentiel de courant (d1), dont le signal de sortie est le premier signal de sortie du comparateur,
- le premier détecteur à valeur de seuil (sd1) contient, dans son second comparateur (c2) en tant qu'étage d'entrée un second amplificateur de transconductance (k2) comportant un couple de transistors à canal p, dont la borne de source commune est alimentée par une source de courant à canal p, et
-- les courants de drain des transistors du couple de transistors à canal p sont appliqués à un second étage différentiel de courant (d2), dont le signal de sortie est le second signal de sortie du comparateur, et
- les premier et second signaux de sortie du comparateur alimentent les deux entrées d'une porte NON-ET (na).

7. Circuit selon la revendication 5, caractérisé par les caractéristiques suivantes :
- le premier détecteur à valeur de seuil (sd1) contient, dans son premier comparateur (c1), en tant qu'étage d'entrée, un premier amplificateur à transconductance (k1) possédant un couple de transistors à canal n, dont la borne de source commune est alimentée par l'intermédiaire d'une source de courant de canal n, et
-- les courants de drain des transistors du couple de transistors à canal n sont coupiés à un premier étage différentiel de courant (d1), dont le signal de sortie est le premier signal de sortie du comparateur,
- le premier détecteur à valeur de seuil (sd1) contient, dans son second comparateur (c2) en tant qu'étage d'entrée un second amplificateur à transconductance (k2) comportant un couple de transistors à canal p, dont la borne de source commune est aiimentée par une source de courant à canal p, et
-- les courants de drain des transistors du couple de transistors à canal p sont couplés à un second étage différentiel de courant (d2), dont le signal de sortie est le second signal de sortie du comparateur, et
- les premier et second signaux de sortie du comparateur alimentent les deux entrées d'une porte NON-ET (na), et
- le second détecteur à valeur de seuil (sd2) est identique au premier détecteur à valeur de seuil (sd1), les seconde et troisième références à valeur de seuil (u2, u3) devant être raccordées aux entrées du nombre à soustraire du premier comparateur associé (c) et du second comparateur associé (c2).
